Europäisches Patentamt

European Patent Office

Office européen des brevets

(19)

(11) Numéro de publication : **0 300 011 B1**

(12) **FASCICULE DE BREVET EUROPEEN**

(45) Date de publication du fascicule du brevet :
27.02.91 Bulletin 91/09

(51) Int. Cl.$^5$ : **H01L 21/76, H01L 21/308**

(21) Numéro de dépôt : 88901280.3

(22) Date de dépôt : 26.01.88

(86) Numéro de dépôt international :
**PCT/FR88/00042**

(87) Numéro de publication internationale :
**WO 88/05603 28.07.88 Gazette 88/17**

(54) **PROCEDE DE FABRICATION DES ZONES D'ISOLATION ELECTRIQUE D'UN CIRCUIT INTEGRE CMOS.**

(30) Priorité : 26.01.87 FR 8700860

(43) Date de publication de la demande :
25.01.89 Bulletin 89/04

(45) Mention de la délivrance du brevet :
27.02.91 Bulletin 91/09

(84) Etats contractants désignés :
**DE FR GB IT NL**

(56) Documents cités :
**EP-A- 0 098 775**
**EP-A- 0 113 517**
**EP-A- 0 132 009**
**US-A- 4 546 538**

(56) Documents cités :
Patent Abstracts of Japan, vol. 10, No. 104 (E-397) 19 April 1986, page 2161 & JP A 60244037 (TOSHIBA K.K.)
Patent Abstracts of Japan, vol. 10, No. 104 (E-397) 19 April 1986, page 2161 & JP A 60244043 (TOSHIBA K.K.)

(73) Titulaire : **COMMISSARIAT A L'ENERGIE ATOMIQUE Etablissement de Caractère Scientifique Technique et Industriel 31/33, rue de la Fédération F-75015 Paris (FR)**

(72) Inventeur : **JEUCH, Pierre 13, rue du Parc F-38170 Seyssins (FR)**

(74) Mandataire : **Lhoste, Catherine et al BREVATOME 25, rue de Ponthieu F-75008 Paris (FR)**

## Description

La présente invention a pour objet un procédé de fabrication de zones d'isolation électrique dans un circuit intégré CMOS.

Elle s'applique en particulier dans le domaine de la microélectronique chaque fois qu'il est nécessaire d'isoler électriquement les uns des autres les composants n et p d'un circuit (transistors, diodes, etc...) réalisé sur un substrat en silicium monocristallin. En particulier, l'invention peut être utilisée pour la réalisation de portes logiques, de bascules, de mémoires mortes ou vives, etc.

La recherche d'une forte densité d'intégration dans les circuits intégrés CMOS nécessite d'utiliser une technique d'isolement spéciale entre les différents composés de ces circuits et notamment entre leurs transistors à canal n et leurs transistors à canal p.

L'une des techniques récentes d'isolation utilisée dans ce but est basée sur la réalisation d'une tranchée d'isolement dans le substrat semi-conducteur, tranchée que l'on oxyde ensuite puis que l'on remplit par un matériau tel que du silicium polycristallin ou de l'oxyde de silicium. Ce remplissage se fait par le dépôt du matériau de remplissage, sur toute la surface du circuit intégré, suivi de l'enlèvement de l'excédent dudit matériau déposé hors des tranchées. On réalise ensuite au-dessus de la tranchée un oxyde de champ localisé (LOCOS).

Cette technique d'isolement par tranchée surmontée d'un oxyde de champ localisé a notamment été décrite dans un article IEDM de 1982, pages 237 à 240, intitulé "Deep Trench Isolated CMOS Devices".

Cette technique d'isolation permet d'atteindre de grandes profondeurs d'isolation (plusieurs micro-mètres) entre les différents composants du circuit intégré, tout en assurant une bonne isolation en surface et tout en évitant la mise en court-circuit des transistors à canal n et des transistors à canal p, phénomène connu sous le nom de "latch up".

Malheureusement, dans une telle technique d'isolation, se pose le problème d'une inversion de conductivité électrique sur les flancs des tranchées d'isolement et donc de la formation de canaux parasites lorsque l'extrémité des canaux des transistors touche les tranchées, là où les grilles des transistors passent sur les tranchées. Ce problème de canal parasite est en particulier décrit dans un article IEDM de 1983, pages 23 à 26 intitulé "Characterization and Modeling of the Trench Surface Inversion Problem for the Trench Isolated CMOS Technology" de Kit M. CHAM et al. ; il nécessite d'éloigner les transistors des tranchées d'isolement et plus spécialement les transistors à canal n de ces circuits, en réalisant une région d'oxyde de champ entre les tranchées et les transistors à l'endroit où la grille de ces transistors passe sur l'isolation latérale correspondante de ces transistors, limitant ainsi la densité d'intégration de ces circuits.

Par ailleurs, le positionnement des tranchées d'isolement entre les régions n et les régions p du substrat dans lesquelles seront réalisés respectivement les transistors à canal p et les transistors à canal n du circuit intégré nécessite l'utilisation de plusieurs masques de lithographie, un masque pour définir l'emplacement des régions n et un masque pour définir l'emplacement des régions p ; difficiles à positionner l'un par rapport à l'autre et limitant encore la densité d'intégration des circuits CMOS.

La présente invention a justement pour objet un procédé de fabrication des zones d'isolation électrique d'un circuit intégré CMOS permettant de remédier aux différents inconvénients donnés ci-dessus.

En particulier, le circuit intégré obtenu selon l'invention, utilisant la technique d'isolation par tranchées d'isolement, présente une densité d'intégration nettement plus élevée que celle des circuits CMOS de l'art antérieur. En outre, ce circuit ne présente pas d'inversion de conductivité électrique sur les flancs des tranchées, et, donc de canaux parasites.

De façon plus précise, l'invention a pour objet un procédé de fabrication de zones d'isolation électrique servant à isoler les régions n des régions p d'un circuit intégré CMOS formées dans un substrat en silicium, caractérisé en ce qu'il comprend les étapes suivantes :

– (a) réalisation d'un premier masque sur le substrat comportant des premiers motifs masquant au moins en partie les régions p,

– (b) réalisation d'un second masque sur le substrat comportant des seconds motifs masquant au moins en partie les régions n, le premier masque, dont les flancs présentent dans leur partie supérieure un profil incliné, pouvant être gravé sélectivement par rapport au second masque, les premiers et seconds motifs étant disjoints et définissant entre eux l'emplacement de tranchées d'isolement électrique à réaliser,

– (c) gravure des régions du substrat non masquées pour former les tranchées,

– (d) gravure simultanée du premier masque et du substrat pour former, dans la partie supérieure des tranchées, des flancs inclinés au contact des régions p, la section des tranchées allant en s'élargissant vers la surface supérieure du substrat.

Par "substrat" il faut comprendre un substrat massif ou une couche épitaxiée sur un substrat massif.

L'utilisation d'une tranchée d'isolement comportant des flancs dissymétriques permet en particulier un surdopage des flancs des tranchées au contact des régions p permettant ainsi de placer les transistors à canal n du circuit au contact des tranchées et en particulier les zones actives n+ de ces transistors. Ceci permet de diminuer notablement la distance entre les régions n et p et donc d'augmenter la densité d'intégration du circuit.

En effet, ce surdopage permet d'éviter toute inversion de conductivité électrique sur les flancs des tranchées d'isolement et en particulier du côté des transistors à canal n.

Le second masque peut être réalisé en siliciure, en métal ou en un composé métallique quelconque autre qu'un siliciure pouvant être gravé sélectivement par rapport au premier masque.

Selon un mode préféré de mise en oeuvre de l'invention, le procédé de fabrication comprend les étapes suivantes :

a') réalisation du premier masque sur la surface supérieure du substrat dont les motifs masquent les régions p,

b') gravure du premier masque afin que ses flancs présentent dans leur partie supérieure un profil incliné,

c') réalisation d'espaceurs en un matériau autre que du silicium et que l'on peut graver sélectivement par rapport au premier masque, sur lesdits flancs,

d') dépôt d'un métal ou siliciure uniquement au-dessus des régions du substrat non recouvertes par le premier masque et les espaceurs,

e') élimination des espaceurs,

f') gravure des régions du substrat mises à nu lors de l'étape précédente afin de former des tranchées,

g') gravure simultanée du premier masque et du substrat pour former, dans la partie supérieure des tranchées, des flancs inclinés situés au contact des régions p, la section des tranchées allant en s'élargissant vers la surface supérieure du substrat,

h') remplissage des tranchées par un matériau de remplissage.

Ce mode de mise en oeuvre de l'invention, contrairement au procédé de l'art antérieur, n'utilise qu'un seul masque de lithographie en résine pour positionner les tranchées d'isolement par rapport aux régions n et aux régions p du circuit intégré. En outre, cet unique masque permet un auto-positionnement des tranchées par rapport aux régions p et n du circuit intégré.

Selon une première variante du procédé selon l'invention, on forme le siliciure au-dessus des régions du substrat non masquées (étape d') en :

– déposant sur la structure obtenue, une couche de métal apte à former un siliciure,

– formant un siliciure à partir du métal uniquement au-dessus des régions du substrat non masquées, et

– éliminant le métal n'ayant pas formé de siliciure.

Selon une seconde variante du procédé selon l'invention, on dépose le métal au-dessus des régions du substrat non masquées (étape d') par un dépôt chimique sélectif en phase vapeur de tungstène ou de palladium. Dans ce cas, les espaceurs et le masque peuvent être réalisés indépendamment en oxyde ou nitrure de silicium.

Le procédé selon l'invention s'applique aussi bien pour une technologie utilisant des caissons de type p, des caissons de type n ou des doubles caissons n et p.

Lors de l'utilisation de caissons n, en particulier dans un substrat de type p, on effectue une implantation d'ions de type n entre les étapes c' et d' pour former les régions n, en utilisant le masque réalisé lors de l'étape a'.

Lors de l'utilisation de caissons p, en particulier dans un substrat de type n, on effectue, entre les étapes g' et h', une implantation d'ions de type p, en utilisant comme masque la métallisation ou la siliciuration réalisée au cours de l'étape d'.

Dans le cas d'une technologie à doubles caissons, les deux implantations ci-dessus doivent bien entendu être réalisées.

Afin de faire diffuser les ions de type n et/ou de type p implantés dans le substrat, on effectue au moins un recuit thermique de la structure.

De façon avantageuse, on grave le premier masque et le substrat de façon anisotrope à des vitesses d'attaque identiques pour le premier masque et le substrat.

Avantageusement, on dépose sur le substrat, avant l'étape a', une couche protectrice puis une couche de silicium polycristallin, la couche protectrice étant réalisée en un matériau qui peut être gravé sélectivement par rapport au silicium polycristallin. La couche protectrice gravée peut être utilisée en particulier comme masque pour réaliser un oxyde de champ localisé, auto-positionné par rapport aux tranchées d'isolement au-dessus desquelles il est réalisé.

La couche en silicium polycristallin permet soit par réaction avec le métal à haute température la formation de siliciure, soit le dépôt sélectif de tungstène, uniquement au-dessus des régions du substrat non masquées.

Comme métal susceptible de former un siliciure on peut utiliser du chrome, du nickel, du cobalt ainsi que tous les métaux réfractaires comme le platine, le palladium, le tungstène, le titane, le molybdène, le tantale, etc. De préférence, on utilise du platine ou du palladium ; les siliciures de ces deux métaux présentent un bon pouvoir d'arrêt pour les ions de type p ; ils constituent donc un bon masque d'implantation pour les ions de type p.

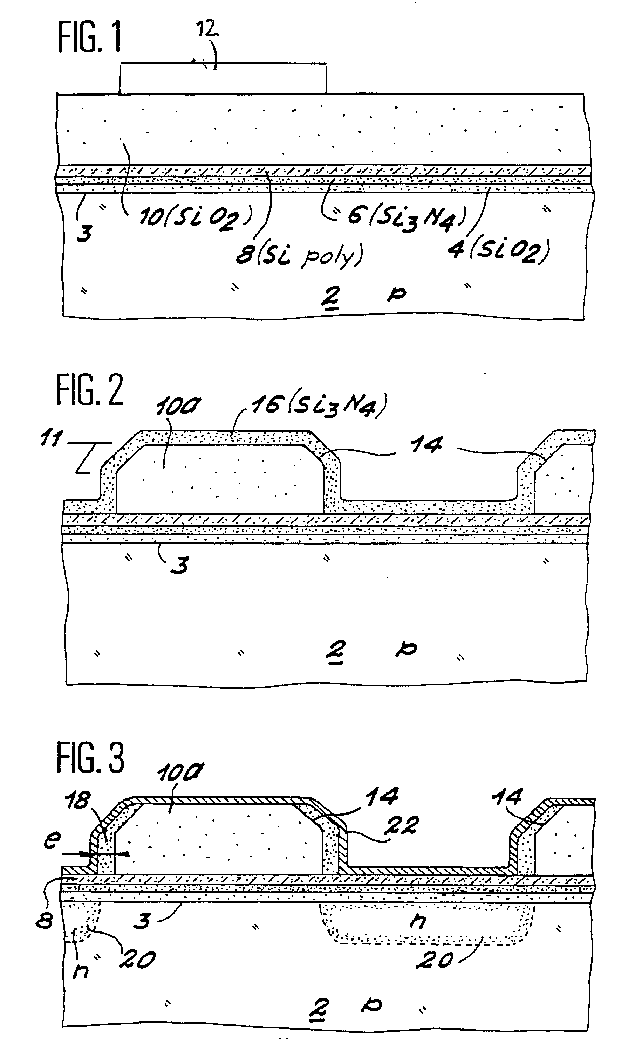

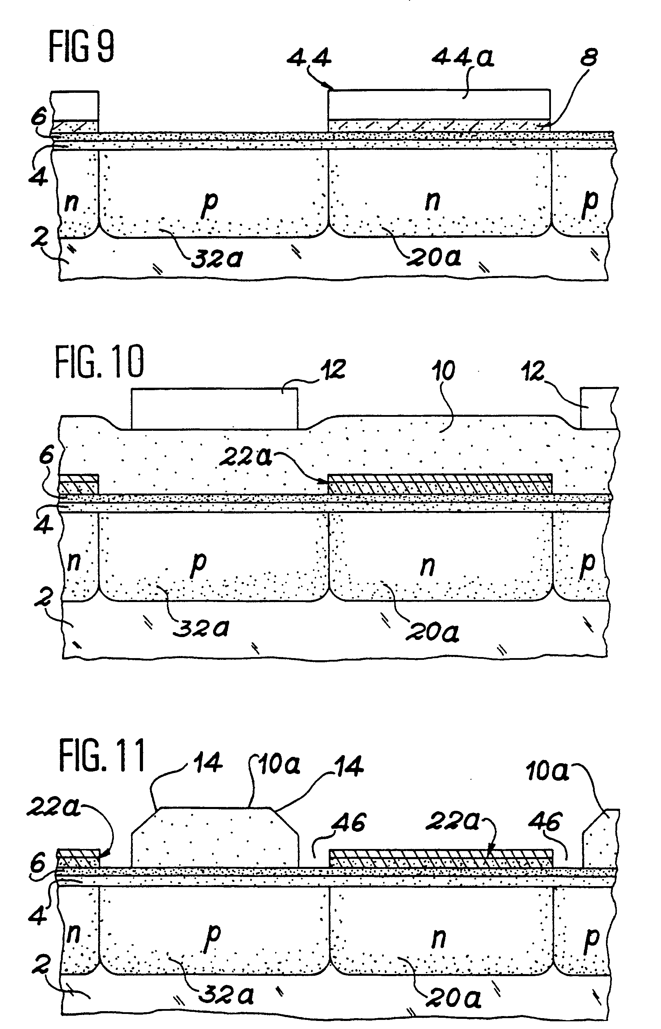

D'autres caractéristiques et avantages de l'invention ressortiront mieux de la description qui va suivre, donnée à titre illustratif et non limitatif, en référence aux figures 1 à 8 annexées représentant schématiquement, en coupe longitudinale, les différentes étapes du procédé de fabrication d'un circuit intégré CMOS conforme à l'invention et aux figures 9 à 11 représentant une variante du procédé.

La description qui va suivre est relative à la fabrication de zones d'isolation électrique d'un circuit CMOS à double caisson n et p, réalisé sur un substrat semiconducteur de type p.

Bien entendu le procédé de l'invention est d'application beaucoup plus générale, comme on l'a vu précédemment.

Comme représenté sur la figure 1, le substrat en silicium monocristallin 2 de type p sur lequel va être réalisé le circuit intégré et ses zones d'isolation, est revêtu sur sa surface supérieure 3 d'une éventuelle couche isolante 4 de préférence en oxyde de silicium (SiO$_2$). Cette couche 4 peut être formée par oxydation thermique du substrat 2 en silicium à une température de l'ordre de 900°C. Cette couche 4 présente une épaisseur de 20 nm environ.

Sur cette couche d'oxyde 4, on dépose ensuite une éventuelle couche d'isolant 6 de préférence en nitrure de silicium (Si$_3$N$_4$) qui sert de couche de protection des caissons n et p ainsi que pour la localisation de l'oxyde de champ réalise ultérieurement. Cette couche 6 présente une épaisseur d'environ 80 nm et peut être obtenue par un dépôt chimique en phase vapeur (CVD ou LPCVD).

La couche d'oxyde de silicium 4 sert de couche de soutien à cette couche de nitrure de silicium 6.

L'étape suivante du procédé consiste à déposer par la technique de dépôt chimique en phase vapeur à basse pression (LPCVD) une couche 8 en silicium polycristallin de 100 nm environ. Cette couche 8 servira ultérieurement pour la formation du siliciure ou le dépôt sélectif de tungstène.

On dépose ensuite une couche d'oxyde de silicium 10 de 2000 nm d'épaisseur environ par dépôt chimique en phase vapeur à basse pression. Sur cette couche 10, on forme alors un masque de résine 12 par les procédés classiques de photolithographie définissant les dimensions et l'emplacement des régions ou caissons n dans lesquels seront réalisés ultérieurement les transistors à canal p du circuit CMOS ; ce masque 12 représentant l'image des régions n permet de ne masquer que les régions du substrat dans lesquelles seront réalisées les caissons p.

On effectue alors une gravure du masque 12 et de la couche d'oxyde de silicium 10 jusqu'à élimination totale des régions de la couche 10 non recouvertes de résine 12. La couche de silicium polycristallin 8 sert de couche d'arrêt à cette gravure.

Cette gravure est réalisée en deux étapes : la première étape se fait de façon anisotrope conventionnelle sur environ 1 µm d'épaisseur. La deuxième étape se fait de façon isotrope pour le masque de résine 12 et de façon anisotrope pour la couche d'oxyde 10. Ceci peut en particulier être réalisé comme décrit dans un article du Journal of Electrochemical Society d'août 1986, intitule "Tapered SiO$_2$ Etch in Diode-Type Reactive Ion Etching", pp 1666-1670.

Cette technique de gravure permet d'obtenir, comme représenté sur la figure 2, une couche d'oxyde de silicium gravée 10a présentant dans sa partie supérieure 11 des flancs inclinés 14, ces flancs inclinés sont tels que la surface inférieure du motif 10a, orientée vers la surface supérieure 3 du substrat 2 est supérieure à la surface opposée dudit motif.

On élimine ensuite ce qui reste du masque de résine 12 à l'aide d'un plasma d'oxygène. Le motif 10a en oxyde de silicium obtenu servira ultérieurement de masque d'implantation pour former les régions n du circuit intégré CMOS.

L'étape suivante du procédé consiste à déposer sur l'ensemble de la structure une couche 16 en nitrure de silicium de 300 nm environ par la technique de dépôt chimique en phase vapeur à basse pression. On effectue ensuite une gravure anisotrope, du type pleine plaque, de la couche 16 par un procédé de gravure ionique réactive en utilisant du CHF$_3$ comme agent d'attaque par exemple, la couche de silicium polycristallin 8 servant d'arrêt à cette gravure.

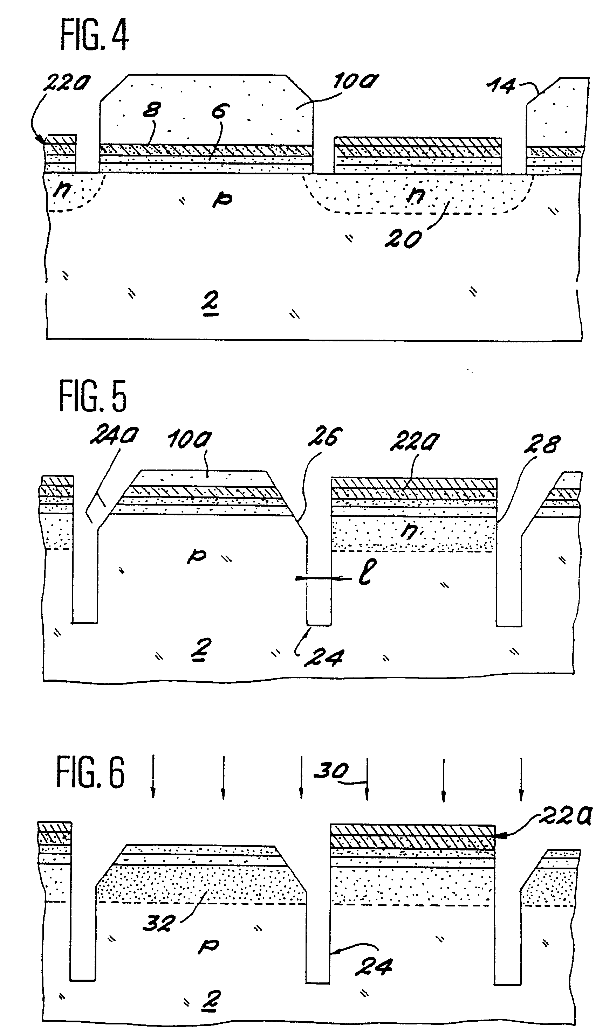

Cette gravure pleine plaque permet d'obtenir sur les flancs du masque 10a, comme représenté sur la figure 3, des espaceurs 18 dont l'épaisseur e est égale à l'épaisseur de la couche de nitrure de silicium 16, soit égale à 300 nm. Ces espaceurs 18 définissent la largeur des tranchées d'isolement à former dans le substrat 2.

A l'aide du masque d'oxyde de silicium 10a et des espaceurs 18, on effectue une implantation d'ions de type n en vue de former des régions 20 de type n dans lesquelles seront réalisés ultérieurement les transistors à canal p. Cette implantation ionique peut être réalisée avec des ions de phosphore à une dose de 1.10$^{13}$ atomes/cm$^2$ avec une énergie de 200 keV.

L'étape suivante selon une première variante du procédé consiste à déposer une couche 22 métallique susceptible de réagir avec le silicium polycristallin de la couche 8 pour former un siliciure. Cette couche métallique est en particulier une couche de platine de 70 nm déposée par pulvérisation cathodique.

On effectue alors un recuit de la structure à 500°C pendant 30 minutes environ de façon à former avec le silicium polycristallin de la couche 8, non masqué par le masque 10a et les espaceurs 18, du siliciure de platine (PtSi) portant la référence 22a sur la figure 4. On élimine ensuite sélectivement le platine n'ayant pas réagi chimiquement, c'est-à-dire le platine situé au contact des espaceurs 18 et du masque 10a, par rapport au PtSi, avec de l'eau régale.

Selon une seconde variante on dépose uniquement sur le silicium polycristallin de la couche 8, non masqué par le masque 10a et les espaceurs, une couche de tungstène 22a par un procédé de dépôt chimique en phase vapeur (CVD ou LPCV) de 100 nm ; le tungstène se dépose sélectivement sur le silicium et non pas sur l'oxyde ou le nitrure de silicium et par conséquent ni sur les espaceurs 18, ni sur le masque 10a.

Cette technique de dépôt a fait l'objet d'une publication Miller et al. dans "Solid State Technology" de décembre 1982, intitulé "CVD Tungstène Interconnect and Contact Barrier Technology for VLSI".

Le siliciure ou le tungstène 22a servira ultérieurement de masque de gravure pour les tranchées d'isolement ainsi que le masque 10a.

En l'absence des couches de $SiO_2$ 4 et de $Si_3N_4$ 6, le siliciure 22a est formé par réaction chimique entre la couche 22 et le silicium du substrat et le dépôt sélectif de tungstène se fait directement sur le substrat.

On élimine ensuite les espaceurs 18 par une solution d'acide orthophosphorique ($H_3PO_4$).

Les étapes suivantes du procédé consistent à éliminer successivement les régions de la couche de silicium polycristallin 8, les régions de la couche de nitrure de silicium 6 et celles de la couche d'oxyde de silicium 4, non recouvertes du masque d'oxyde de silicium 10a et de siliciure ou de tungstène 22a. Ceci peut être réalisé par des gravures ioniques réactives successives en utilisant comme agent d'attaque de l'hexafluorure de soufre pour les couches 8 et 6 et du $CHF_3$ pour la couche 4.

On effectue alors, comme représenté sur la figure 5, une gravure des régions du substrat 2 mises à nu lors de l'étape précédente, afin de former les tranchées d'isolement 24. La gravure du substrat est réalisée sur une profondeur de l'ordre de 4000 nm par un procédé de gravure ionique réactive, sélectif par rapport au siliciure ou au tungstène 22a. A cet effet, on utilise comme agent d'attaque un mélange de $CCl_4$ et de $Cl_2$.

Conformément au mode de réalisation préféré de l'invention, la largeur minimale l des tranchées 24 est égale à l'épaisseur e des espaceurs (figure 3) et donc voisine de 300 nm.

Le procédé selon ce mode de l'invention permet, grâce à l'emploi des espaceurs et de la formation du siliciure ou du dépôt sélectif de tungstène 22a, la réalisation de tranchées d'isolement 24 submicroniques contrairement au procédé actuellement connu d'isolation par tranchées. L'obtention de tranchées submicroniques permet alors d'augmenter de façon considérable la densité d'intégration du circuit intégré. En outre, elles sont auto-positionnées par rapport aux régions n et p du circuit intégré.

L'étape suivante du procédé consiste à former, comme représenté sur la figure 5, dans la partie supérieure 24a des tranchées 24 des flancs dissymétriques ; les flancs 26 au contact des régions p sont inclinés par rapport à la surface 3 du substrat 2, alors que les flancs 28 au contact des régions n sont perpendiculaires à cette surface 3. Les flancs 26 sont inclinés de façon que la section des tranchées soit maximum au niveau de la surface 3 du substrat.

Pour former ces flancs inclinés 26, on effectue une gravure anisotrope simultanée du masque 10a et du substrat 2 à des vitesses d'attaque identiques pour le masque 10a et le substrat. Ceci peut être réalisé en utilisant une gravure ionique réactive avec comme mélange d'attaque du $CHF_3$ et de l'oxygène, sur une épaisseur de 500 nm environ. Cet agent d'attaque ne permet pas d'attaquer le siliciure ou le tungstène 22a qui servira ultérieurement de masque d'implantation pour réaliser les régions p du circuit CMOS.

Ensuite, on élimine le masque d'oxyde de silicium 10a par attaque chimique avec de l'acide fluorhydrique, puis le restant de silicium polycristallin 8 par action d'un plasma de $SF_6$. La structure obtenue est celle représentée sur la figure 6.

On effectue alors une implantation 30 d'ions de type p afin de former les caissons p portant la référence 32 dans lesquels seront réalisés ultérieurement les transistors à canal n. Cette implantation 30 peut être réalisée avec des ions de bore à une dose de $2,5.10^{12}$ atomes/$cm^2$ et une énergie de 60 keV. Le siliciure de platine 22a ou le tungstène sert de masque à cette implantation 30 et permet l'auto-positionnement des régions 32 p par rapport aux tranchées 24.

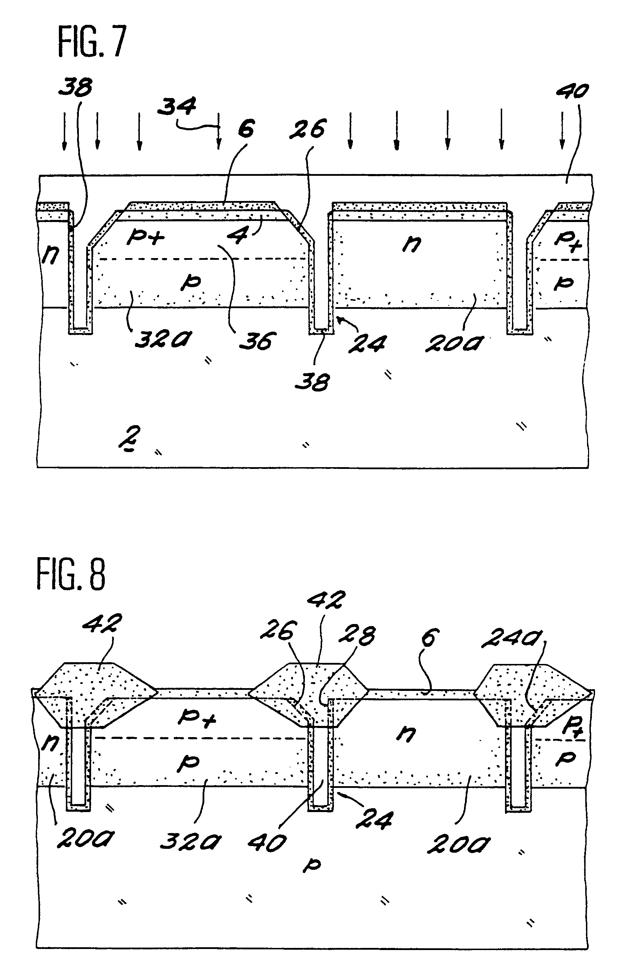

Après élimination du siliciure ou du tungstène 22a, comme représenté sur la figure 7, par une solution à base d'acide nitrique et d'acide fluorhydrique, on effectue un recuit à 1175°C pendant 5 heures environ afin de faire diffuser dans le substrat les ions de phosphore et les ions de bore implantés pour former respectivement les caissons n 20a et les caissons p 32a.

L'étape suivante du procédé consiste à effectuer un surdopage des flancs inclinés 26 adjacents aux caissons p 32a en vue d'éviter l'inversion de conductivité électrique sur les flancs des tranchées d'isolement 24 et donc la formation de canaux parasites. Ce surdopage peut être réalisé par une implantation 34 de $BF_2$ à une dose de $5.10^{13}$ atomes/$cm^2$ et une énergie de 40 keV ; il porte la référence 36 sur la figure 7.

On effectue alors une oxydation thermique de la structure à une température de l'ordre de 900°C. Cette oxydation permet d'obtenir un film d'oxyde 38 d'environ 100 nm recouvrant en particulier les flancs et le fond de la tranchée 24. Cette oxydation thermique permet d'améliorer l'isolation électrique par tranchées d'isolement.

On effectue alors le remplissage de la tranchée par un matériau 40 constitué par du silicium polycristallin ou un siliciure ($WSi_2$ par exemple). Ce remplissage est réalisé par un dépôt isotrope et notamment par la technique de dépôt chimique en phase vapeur (CVD ou LPCVD) de manière à remplir complètement les tranchées 24.

Après ce remplissage des tranchées 24, on élimine l'excédent de matériau de remplissage 40 se trouvant hors des tranchées 24 de façon à ne laisser du matériau 40 qu'à l'intérieur des tranchées 24, comme représenté sur la figure 8. Cette élimination est réalisée par une gravure sèche pleine plaque du type ionique réactive avec du $CCl_4$, attaque sélective par rapport à la couche de nitrure de silicium 6.

On réalise ensuite l'oxyde de champ localisé 42, de façon classique en formant sur l'ensemble de la structure un masque de lithographie protégeant les régions actives du circuit (transistors notamment), en gravant la couche de nitrure 6 pour en éliminer les régions non masquées, en éliminant le masque de lithographie puis en oxydant thermiquement à 950°C le matériau de remplissage 40 des tranchées ainsi que les régions du substrat mises à nu lors de la gravure du nitrure, la couche de nitrure de silicium 6 gravée servant à la localisation de cet oxyde de champ 42. L'épaisseur de cet oxyde est voisine de 600 nm.

Enfin, on élimine la couche de nitrure de silicium 6, par exemple par une gravure chimique à l'aide de l'acide orthophosphorique. La structure finale du circuit CMOS est celle représentée sur la figure 8.

Grâce au procédé de l'invention, l'oxyde de champ localisé 42 est autopositionné par rapport aux tranchées d'isolement 24. Ceci contribue à augmenter de façon notable la densité d'intégration des circuits intégrés CMOS.

Les transistors à canal n et les transistors à canal p du circuit CMOS peuvent alors être réalisés de façon classique respectivement dans les caissons p 32a et n 20a.

La description ci-dessus concernait une mise en oeuvre dans laquelle on n'utilisait qu'un seul masque de résine pour positionner les caissons n et les caissons p ; ils sont donc auto-positionnés. En outre, les tranchées d'isolement sont auto-positionnées par rapport aux caissons n et aux caissons p. Toutefois, il est possible d'utiliser plusieurs masques lithographiques en résine non auto-positionnés par rapport aux régions n et p pour la mise en oeuvre de l'invention, comme cela est représenté sur les figures 9 à 11.

Après réalisation des régions p 32a et/ou n 20a, de façon connue (masques lithographiques complémentaires, implantation d'ions et recuit), on dépose successivement les couches 4, 5 et 8 de $SiO_2$, $Si_3N_4$ et de Si polycristallin, comme décrit ci-dessus. On réalise alors, par les procédés classiques de photolithographie un masque de résine 44 dont les motifs 44a masquent les régions n.

On effectue alors une gravure anisotrope de la couche 8 de silicium polycristallin conduisant à l'élimination des régions non masquées de la couche 8, comme schématisé sur la figure 9. Cette gravure est une gravure du type ionique réactive utilisant du $CCl_4$ comme gaz d'attaque.

Après élimination du masque de résine 44, on forme le masque 22a soit en silicure par réaction chimique d'un métal avec la couche 8, soit par dépôt sélectif de tungstène, comme décrit en référence aux figures 3 et 4, sur les régions n 20a. Puis on dépose la couche 10 de $SiO_2$, comme décrit à la figure 1, sur l'ensemble de la structure.

Ensuite, on réalise le masque de résine 12 dont les motifs masquent en partie les régions p, puis on grave simultanément le masque 12 et la couche de $SiO_2$ comme décrit ci-dessus, pour former une couche de $SiO_2$ gravée 10a présentant dans sa partie supérieure 11 des flancs inclinés 14. On élimine alors les régions de la couche de nitrure 6 et celles de la couche 4 de $SiO_2$ non recouvertes des masques 10a et 22. La suite du procédé est identique à celle décrite précédemment en référence aux figures 5 à 8 à l'exception de l'implantation d'ions de type p servant à la formation des caissons p 32a.

Conformément à l'invention les espaces 46 situés entre deux motifs 10a et 22a fixent les positions des tranchées d'isolement 24 ainsi que la largeur l de ses tranchées.

Selon l'invention, il est possible d'utiliser un composé métallique comme masque 22a, à la place du tungstène ou du silicure, l'important étant que le masque 22a ne s'érode pas ou ne s'érode que très faiblement lorsque l'on grave le masque de résine 12 et la couche d'oxyde de silicium 10. Comme composé métallique utilisable dans l'invention, on peut citer l'alumine ; cette dernière doit être déposée directement sur la couche de nitrure 6, par "lift-off" (réalisation d'un masque de résine masquant les régions p 32a, dépôt d'alumine sur l'ensemble de la structure et élimination du masque ainsi que l'alumine recouvrant la résine).

Quel que soit le mode de mise en oeuvre de l'invention, le masque de résine 12 masquant les régions p et le "masque" 22a en silicure ou en tungstène masquant les régions n sont complémentaires ou auto-positionnés ; autrement dit la position des motifs 12 et donc celle des motifs 10a fixent celle des motifs 22a (figures 1-4) ou inversement la position des motifs 22a fixe celle des motifs du masque 12 et donc celle des motifs 10a (figures 9-11).

## Revendications

1. Procédé de fabrication de zones d'isolation électrique (24, 38, 42) servant à isoler les régions n (20a) des régions p (32a) d'un circuit intégré CMOS formées dans un substrat en silicium (2), caractérisé en ce qu'il comprend les étapes suivantes :
  - (a) réalisation d'un premier masque sur le substrat (2) comportant des premiers motifs (10a) masquant au moins en partie les régions p (32a),
  - (b) réalisation d'un second masque sur le substrat comportant des seconds motifs (22a) masquant au moins en partie les régions n (20a), le premier masque, dont les flancs présentent dans leur partie supérieure un profil incliné, pouvant être gravé sélectivement par rapport au second masque, les premiers et seconds motifs étant disjoints et définissant entre eux l'emplacement de tranchées d'isolement électrique (24) à réaliser,

– (c) gravure des régions du substrat (2) non masquées pour former les tranchées (24),

– (d) gravure simultanée du premier masque (10a) et du substrat (2) pour former, dans la partie supérieure (24a) des tranchées (24), des flancs inclinés (26) au contact des régions p (32a), la section des tranchées (24) allant en s'élargissant vers la surface supérieure (3) du substrat (2).

2. Procédé de fabrication selon la revendication 1, caractérisé en ce que le second masque (22a) est un métal ou un siliciure.

3. Procédé de fabrication selon la revendication 1, caractérisé en ce que l'on remplit les tranchées d'isolement (24) par un matériau de remplissage (40).

4. Procédé de fabrication selon la revendication 1, caractérisé en ce qu'il comprend les étapes suivantes :

a') réalisation du premier masque sur la surface supérieure du substrat (2) comportant des motifs (10a) masquant des régions p (32a),

b') gravure du premier masque (10a) afin que ses flancs (14) présentent dans leur partie supérieure (11) un profil incliné,

c') réalisation d'espaceurs (18) sur lesdits flancs (14),

d') dépôt d'un métal ou d'un siliciure (22a) uniquement au-dessus des régions du substrat non recouvertes par le premier masque et les espaceurs,

e') élimination des espaceurs (18),

f') gravure des régions du substrat (2) mises à nu lors de l'étape précédente afin de former des tranchées (24),

g') gravure simultanée du premier masque (10a) et du substrat (2) pour former, dans la partie supérieure (24a) des tranchées (24), des flancs inclinés (26) situés au contact des régions p (32a), la section des tranchées (24) allant en s'élargissant vers la surface supérieure (3) du substrat (2),

h') remplissage des tranchées (24) par un matériau de remplissage (40).

5. Procédé de fabrication selon la revendication 4, caractérisé en ce que l'on forme le siliciure au-dessus des régions du substrat non masquées en :

– déposant sur la structure obtenue, une couche de métal (22) apte à former un siliciure (22a),

– formant un siliciure (22a) à partir du métal uniquement au-dessus des régions du substrat non masquées, et

– éliminant le métal (22) n'ayant pas formé de siliciure (22a).

6. Procédé de fabrication selon la revendication 4, caractérisé en ce que les espaceurs (18) et le premier masque (10a) sont réalisés en nitrure de silicium et/ou en oxyde de silicium et en ce que l'on dépose le dépôt chimique sélectif en phase vapeur de tungstène.

7. Procédé de fabrication selon la revendication 1, caractérisé en ce que l'on effectue entre un dopage (36) de type p dans les flancs inclinés (26) des tranchées.

8. Procédé de fabrication selon la revendication 4, caractérisé en ce que l'on effectue une implantation d'ions de type n, entre les étapes c' et d', pour former les régions n (20a).

9. Procédé selon la revendication 4, caractérisé en ce que l'on effectue, entre les étapes g' et h', une implantation (30) d'ions de type p pour former les régions p (32a).

10. Procédé de fabrication selon la revendication 8 ou 9, caractérisé en ce que l'on effectue, après l'implantation, un recuit pour faire diffuser les ions implantés dans le substrat (2).

11. Procédé de fabrication selon la revendication 4, caractérisé en ce que l'on dépose sur le substrat (2), avant l'étape a', une couche protectrice (6) puis une couche de silicium polycristallin (8), et en ce que l'on élimine les régions de cette couche protectrice puis celles de cette couche de silicium, mises à nu lors de l'étape e', entre les étapes e' et f'.

12. Procédé de fabrication selon la revendication 11, caractérisé en ce que l'on forme un siliciure (22a) par réaction d'un métal (22) et du silicium polycristallin (8) à haute température dans les régions de la couche de silicium polycristallin non masquées.

13. Procédé de fabrication selon la revendication 5 ou 11, caractérisé en ce que le métal est choisi parmi le platine et le palladium.

14. Procédé de fabrication selon la revendication 1, caractérisé en ce que l'on grave le premier masque (10a) et le substrat (2) de façon anisotrope à des vitesses d'attaque identiques pour le premier masque et le substrat.

15. Procédé de fabrication selon la revendication 4, caractérisé en ce que l'on effectue une oxydation thermique du substrat (2) entraînant la formation d'un film d'oxyde (38) sur les flancs et le fond des tranchées (24).

16. Procédé de fabrication selon la revendication 4, caractérisé en ce que l'on réalise après l'étape h' un oxyde de champ localisé (42) au-dessus de chaque tranchée (24).

17. Procédé de fabrication selon la revendication 4, caractérisé en ce que l'on élimine le restant du premier masque (10a) et le siliciure (22a) par gravure, entre les étapes g' et h'.

**Ansprüche**

1. Verfahren zum Herstellen von elektrischen Isolationszonen (24, 38, 42) zum Isolieren der n-Bereiche (20a) von den p-Bereichen (32a) eines integrierten CMOS-Schaltkreises, die in einem Siliziumsubstrat (2) gebildet sind, dadurch gekennzeichnet, daß es folgende Verfahrensschritte aufweist :

- (a) Bilden einer ersten Maske auf dem Substrat (2) mit ersten Mustern (10a), die wenigstens teilweise die p-Bereiche (32a) bedecken,
- (b) Bilden einer zweiten Maske auf dem Substrat mit zweiten Mustern (22a), die wenigstens teilweise die n-Bereiche (20a) bedecken, wobei die erste Maske, deren Flanken in ihrem oberen Bereich ein abgeschrägtes Profil aufweisen, selektiv bezüglich der zweiten Maske geätzt werden kann, wobei die ersten und zweiten Muster nicht miteinander verbunden sind und zwischen sich die Stelle für zu bildende elektrische Isoliergräben (24) bilden,
- (c) Ätzen der nicht maskierten Bereiche des Substrats (2) zum Bilden der Gräben (24),
- (d) gleichzeitiges Ätzen der ersten Maske (10a) und des Substrats (2) zum Bilden von Schrägen Flanken (26) im oberen Bereich der Gräben (24) In Kontakt mit den p-Bereichen (32a), wobei der Querschnitt der Graben (24) elch zur oberen Oberflache (3) des Substrats (2) erweitert.

2. Herstellungeverfahren nach Anspruch 1, dadurch gekennzeichnet, daß die zweite Maske (22a) ein Metall oder ein Silizid ist.

3. Herstellungsverfahren nach Anspruch 1, dadurch gekennzeichnet, daß man die Isoliergräben (24) mit einem Füllmaterial (40) auffüllt.

4. Herstellungsverfahren nach Anspruch 1, dadurch gekennzeichnet, daß es folgende Verfah-rensschritte aufweist :

a') Bilden der ersten Maske auf der oberen Oberfläche des Substrats (2) mit Mustern (10), die p-Bereiche (32a) abdecken,
b') Ätzen der ersten Maske (10a), so daß ihre Flanken (14) in ihrem oberen Bereich (11) ein abgeschrägtes Profil besitzen,
c') Bilden von Abstandsstücken (18) auf den Flanken (14),
d') Abscheiden eines Metalls oder Silizids (22a) nur auf den Substratbereichen, die nicht von der ersten Maske und den Abstandsstücken bedeckt sind,
e') Entfernen der Abstandsstücke (18),
f') Ätzen der Bereiche des Substrats (2), die durch den vorhergehenden Verfahrensschritt freigelegt wurden, um Gräben (24) zu bilden,
g') gleichzeitiges Ätzen der ersten Maske (10a) und des Substrats (2), um im oberen Bereich (24a) der Gräben (24) schräge Flanken (26) zu bilden, die sich in Kontakt mit den p-Bereichen (32a) befinden, wobei sich der Querschnitt der Gräben zur oberen Oberfläche (3) des Substrats (2) hin erweitert,
h') Auffüllen der Gräben (24) durch ein Füllmaterial.

5. Herstellungsverfahren nach Anspruch 4, dadurch gekennzeichnet, daß man das Silizid auf den nicht maskierten Substratbereichen bildet, indem man :

- auf die erhaltene Struktur eine Metallschicht (22) abscheidet, die geeignet ist ein Silizid (22a) zu bilden,
- ausgehend von dem Metall ein Silizid (22a) nur auf den unmaskierten Substratbereichen bildet, und
- das Metall (22), das kein Silizid (22a) gebildet hat, entfernt.

6. Herstellungsverfahren nach Anspruch 4, dadurch gekennzeichnet, daß die Abstandsstücke (18) und die erste Maske (10a) aus Siliziumnitrid und-/oder Siliziumoxyd hergestellt werden und daß man die selektive chemische Abscheidung in der Dampfphase des Wolframs abscheidet.

7. Herstellungsverfahren nach Anspruch 1, dadurch gekennzeichnet, daß man zwischen einer Dotierung (36) vom p-Typ in den schrägen Flanken (26) Gräben ausführt.

8. Herstellungsverfahren nach Anspruch 4, dadurch gekennzeichnet, daß man zwischen den Verfahrensschritten c' und d' eine Ionenimplantation vom n-Typ zum Bilden der n-Bereiche (20a) ausführt.

9. Herstellungsverfahren nach Anspruch 4, dadurch gekennzeichnet, daß man zwischen den Verfahrensschritten g' und h' eine Ionenimplantation (30) vom p-Typ zum Bilden der p-Bereiche (32a) ausführt.

10. Herstellungeverfahren nach Anspruch 8 oder 9, dadurch gekennzeichnet, daß man nach einer Implantation eine Aufheizung zum Diffundieren der Implantierten Ionen in das Substrat durchführt.

11. Herstellungsverfahren nach Anspruch 4, dadurch gekennzeichnet, daß man auf dem Substrat (2) vor dem Verfahrensschritt a' eine Schutzschicht (6) und dann eine Schicht aus polykrietallinem Sili-zium (8) abscheidet und daß man zwischen den Ver-fahrensschritten e' und f' die Bereiche dieser Schutzschicht und dann die dieser Siliziumschicht entfernt, die während des Verfahrensschritts e' freige-legt werden.

12. Herstellungsverfahren nach Anspruch 11, dadurch gekennzeichnet, daß man ein Silizid (22a) durch Reaktion eines Metalls (22) mit dem polykristallinen Silizium (8) bei hoher Temperatur in den unmaskierten Bereichen der polykristallinen Siliziumschicht durchführt.

13. Herstellungsverfahren nach Anspruch 5 oder 11, dadurch gekennzeichnet, daß das Metall aus Platin und Palladium ausgewählt wird.

14. Herstellungsverfahren nach Anspruch 1, dadurch gekennzeichnet, daß man die erste Maske (10a) und das Substrat (2) anisotrop mit identischen Ätzraten für die erste Maske und das Substrat ätzt.

15. Herstellungsverfahren nach Anspruch 4, dadurch gekennzeichnet, daß man eine thermische Oxydation des Substrats (2) durchführt, die zur Bildung eines Oxydfilms (38) auf den Flanken und dem Boden der Gräben (24) führt.

16. Herstellungsverfahren nach Anspruch 4, dadurch gekennzeichnet, daß man nach dem Verfahrensschritt h' ein lokales Feldoxyd (42) über jedem Graben (24) erzeugt.

17. Herstellungsverfahren nach Anspruch 4, dadurch gekennzeichnet, daß man zwischen den Verfahrensschritten g' und h' den Rest der ersten Maske (10a) und das Silizid (22a) durch Ätzen entfernt.

## Claims

1. Process for the production of electrical isolation zones (24, 38, 42) serving to isolate the n regions (20a) from the p regions (32a) of a CMOS integrated circuit formed in a silicon substrate (2), characterized in that it comprises the following stages :

(a) producing a first mask on the substrate (2) having first patterns (10a) masking at least partly the p regions (32a),

(b) producing a second mask on the substrate having second patterns (22a) masking at least partly the n regions (20a), the first mask, whose sides have in their upper part an inclined profile, being selectively etchable with respect to the second mask, the first and second patterns being separate and defining between them the location of the electrical isolation trenches (24) to be produced,

(c) etching the unmasked substrate regions (2) for forming the trenches (24),

(d) simultaneously etching the first mask (10a) and the substrate (2) for forming, in the upper part (24a) of the trenches (24), inclined sides (26) in contact with the p regions (32a), the section of the trenches (24) wedening towards the upper surface (3) of the substrate (2).

2. Production process according to claim 1, characterized in that the second mask (22a) is of metal or silicide.

3. Production process according to claim 1, characterized in that the isolation trenches (24) are filled with a filling material (40).

4. Production process according to claim 1, characterized in that it comprises the following stages :

a') producing the first mask on the upper surface of the substrate (2), whose patterns (10a) mask the p regions (32a),

b') etching the first mask (10a) so that its sides (14) have an inclined profile in their upper part (11),

c') producing spacers (18) on said sides (14),

d') deposition of a metal or a silicide (22a) solely above the regions of the substrate not covered by the first mask and the spacers,

e') elimination of the spacers (18),

f') etching the regions of the substrate (2) exposed during the preceding stage in order to form trenches (24),

g') simultaneous etching of the first mask (10a) and the substrate (2) for forming, in the upper part (24a) of the trenches (24), inclined sides (26) in contact with the p regions (32a), the section of the trenches (24) widening towards the upper surface (3) of the substrate (2),

h') filling the trenches (24) with a filling material (40).

5. Production process according to claim 4, characterized in that the silicide is formed above the unmasked substrate regions by depositing on the structure obtained a metal layer (22) able to form a silicide (22a), forming a silicide (22a) from said metal solely above the unmasked substrate regions and eliminating the metal (22) which has not formed silicide (22a).

6. Production process according to claim 4, characterized in that the spacers (18) and first mask (10a) ate made from silicon nitride and/or silicon oxide and in that there is selective chemical vapour phase deposition of tungsten.

7. Production process according to claim 1, characterized in that a p type doping (36) takes place in the inclined sides (26) of the trenches.

8. Production process according to claim 4, characterized in that n ion implantation takes place between stages c' and d' for forming the n regions (20a).

9. Production process according to claim 4, characterized in that between stages g' and h' p ion implantation (30) takes place for forming the p regions (32a).

10. Production process according to claims 8 or 9, characterized in that, after implantation, an annealing takes place for diffusing the implanted ions into substrate (2).

11. Production process according to claim a, characterized in that, before stage a', on substrate (2) is deposited a protective layer (6) and then a polycristalline silicon layer (8) and in that the regions of said protective layer and then those of the silicon layer exposed during stage e' and between stages e' and f' are eliminated.

12. Production process according to claim 11, characterized in that a silicide (22a) is formed by the reaction of a metal (22) and the polycrystalline silicon (8) at high temperature in the unmasked polycrystalline silicon layer regions.

13. Production process according to claims 5 or 11, characterized in that the metal is chosen from among platinum and palladium.

14. Production process according to claim 1, characterized in that the first mask (10a) and substrate (2) are etched anisotropically at identical etching speeds for the first mask and the substrate.

15. Production process according to claim 4, characterized in that a thermal oxidation of substrate (2) takes place leading to the formation of an oxide film (38) on the sides and bottom of trenches (24).

16. Production process according to claim 4, characterized in that, after stage h', a local field oxide (42) is produced above each trench (24).

17. Production process according to claim 4, characterized in that the remainder of the first mask (10a) and the silicide (22a) is eliminated by etching between stages g' and h'.

FIG. 1

12

3  10(SiO₂)  6(Si₃N₄)

8(Si poly)  4(SiO₂)

2  p

FIG. 2

100  16(Si₃N₄)

11  14

3

2  p

FIG. 3

100

18  14  14

22

e

8

3  n

8  n

20  n  20

2  p

# FIG. 4

220  8  6  10a  14

n  p  n

20

2

# FIG. 5

24a  10a  26  22a  28

p  n

ℓ

2  24

# FIG. 6

30

22a

32  24

p

2

# FIG. 7

38    34    6    26    40

38    n    P+    4    26    n    P+    p

32a    36    24    20a    38

2

# FIG. 8

42    42    6    24a
26    28

42    n    P+    28    n    P+    p

20a    32a    40    24    20a
P

FIG 9

FIG. 10

FIG. 11